# FASCICULE DE BREVET EUROPEEN

(11) **EP 3 409 996 B1**
(45) Date de publication et mention de la délivrance du brevet: **29.01.2020**
(21) Numéro de dépôt: 18174718.9
(22) Date de dépôt: 29.05.2018
(51) Int. Cl.: F16M 11/04, E05B 73/00, F16M 11/10, G06Q 20/00, G07F 7/00

(54) **ADAPTATEUR POUR LA FIXATION D'UN TERMINAL DE PAIEMENT ELECTRONIQUE SUR UN SUPPORT**
ADAPTER ZUR BEFESTIGUNG EINES ELEKTRONISCHEN ZAHLUNGSTERMINALS AUF EINER HALTERUNG
ADAPTER FOR SECURING AN ELECTRONIC PAYMENT TERMINAL TO A MOUNTING

(30) Priorité: 01.06.2017 FR 1754876
(43) Date de publication de la demande: 05.12.2018
(73) Titulaire: INGENICO GROUP, 75015 Paris (FR)
(72) Inventeur: MAYER, Laurent, 95800 COURDIMANCHE (FR); BLOT, Pierre, 44000 NANTES (FR); BALASSE, Johann, 92400 COURBEVOIE (FR)
(74) Mandataire: Vidon Brevets & Stratégie

(56) Documents cités:
- EP-A2- 2 463 746
- WO-A1-2011/111000
- NL-C2- 1 012 402

## Description

### 1. DOMAINE DE L'INVENTION

Le domaine de l'invention est celui des terminaux électroniques.

Plus précisément, l'invention concerne des terminaux de paiement électronique destinés à être utilisés sur des supports fixes et la solidarisation de ces terminaux sur ces supports.

### 2. ARRIÈRE-PLAN TECHNOLOGIQUE

On s'attache plus particulièrement dans la suite de ce document à décrire la problématique existant dans le domaine des terminaux de paiement électronique, à laquelle ont été confrontés les inventeurs de la présente demande de brevet. L'invention ne se limite bien sûr pas à ce domaine particulier d'application, mais présente un intérêt pour tous terminaux électroniques devant faire face à une problématique proche ou similaire.

On connaît, dans l'état de la technique, des supports tels que des pieds de fixation ou des mâts sur lesquels sont fixés des terminaux de paiement électronique. On retrouve fréquemment ce type de dispositif aux caisses des magasins.

Les terminaux de paiement électronique sont solidarisés à ces supports par le biais d'un système de vis qui empêchent que le terminal de paiement électronique ne se décroche du support et ne chute.

Pour des raisons de sécurité, il est préférable que les terminaux de paiement électronique soient désolidarisés de leur support et placés dans un coffre sécurisé lorsqu'ils ne sont pas utilisés, par exemple en dehors des horaires d'ouverture du commerce.

Ainsi, avant l'ouverture de son commerce, le commerçant doit solidariser chacun des terminaux de paiement électronique de son parc sur leur support respectif à l'aide d'un outil classique (un tournevis). Ensuite, lors de la fermeture de son commerce, le commerçant doit désolidariser les terminaux de paiement électronique de leur support pour les ranger dans le coffre sécurisé.

Selon cette technique connue, pour effectuer l'opération de paiement, le commerçant saisit le montant de la transaction sur le terminal de paiement électronique puis fait pivoter ce dernier, par rotation du support, vers le client afin qu'il puisse effectuer la transaction en toute confidentialité (insertion de la carte puis saisie du code PIN).

Un inconvénient de cette technique connue réside dans le fait que les opérations de solidarisation et de désolidarisation des terminaux de paiement électronique sur leur support, qui peuvent être réalisées plusieurs fois par jour, sont chronophages pour la personne qui les réalise.

En outre, la nécessité d'utiliser un outil, bien que classique, complique l'installation et la désinstallation des terminaux et affecte donc également le temps nécessaire à la réalisation de ces opérations.

Un exemple d'adaptateur selon le préambule de la revendication 1 est divulgué dans le document EP2463746.

En d'autres termes, il n'existe actuellement aucun système simple et rapide permettant de solidariser et désolidariser un terminal de paiement électronique à un support.

### 3. EXPOSÉ DE L'INVENTION

L'invention propose un adaptateur pour la solidarisation réversible d'un terminal de paiement électronique à un support.

Selon l'invention, l'adaptateur comprend un corps sur lequel est monté un clip de solidarisation réversible du terminal de paiement électronique au support. Selon l'invention, le corps présente en outre au moins deux trous traversants situés de part et d'autre d'une encoche et destinés à coopérer avec des moyens de verrouillage du terminal de paiement électronique sur l'adaptateur. Ainsi, l'adaptateur présente des moyens de réception de moyens de verrouillage permettant, si le commerçant le souhaite, de verrouiller le terminal de paiement électronique sur l'adaptateur afin d'assurer une sécurité supérieure par rapport au simple clipsage du terminal de paiement électronique sur l'adaptateur.

Ainsi, l'invention repose sur une approche nouvelle et inventive de solidarisation et de désolidarisation d'un terminal de paiement électronique sur un support (par exemple un pied de fixation), par la mise en œuvre d'un adaptateur, entre le support et le terminal de paiement électronique, comprenant un clip de solidarisation du terminal de paiement électronique au support.

L'utilisation d'un tel adaptateur permet une installation/désinstallation rapide du terminal de paiement électronique sur son support par le commerçant car, contrairement à l'art antérieur, la mise en œuvre du clip de solidarisation permet de s'affranchir de l'utilisation d'un outil pour solidariser/désolidariser le terminal de paiement électronique au/du support.

En effet, selon les techniques connues, les terminaux de paiement électronique sont fixés à leur support par le biais d'au moins une vis et il est donc nécessaire d'utiliser un outil (un tournevis) pour solidariser et désolidariser le terminal de paiement électronique du support.

Le clip de solidarisation de l'invention facilite l'installation et la désinstallation du terminal de paiement électronique sur son support puisqu'une simple pression de l'utilisateur sur le clip permet la solidarisation/désolidarisation du terminal de paiement électronique.

Selon un aspect particulier de l'invention, le clip est monté pivotant sur le corps de l'adaptateur.

Selon un autre aspect particulier de l'invention, le clip présente un élément de rappel situé entre le clip et le corps.

Ainsi, la solidarisation et la désolidarisation du terminal de paiement électronique sur le support s'effectuent par une simple pression de l'utilisateur sur le clip, par exemple via le terminal de paiement électronique. Cette pression doit simplement être supérieure à la force de rappel de l'élément de rappel.

Selon un aspect particulier de l'invention, l'élément de rappel se présente sous la forme d'un ressort.

Selon un autre aspect particulier de l'invention, le corps présente au moins un trou de passage de moyens de fixation de l'adaptateur sur le support.

La mise en œuvre de ce trou permet de fixer l'adaptateur sur tout support. Par exemple, les moyens de fixation se présentent sous la forme de deux vis de fixation qui passent à travers deux trous ménagés dans l'adaptateur et viennent ensuite coopérer avec deux trous taraudés ménagés sur le support. Ces moyens de fixation de l'adaptateur au support ne sont pas accessibles lorsque le terminal de paiement électronique est solidarisé à l'adaptateur, assurant ainsi un niveau de sécurité élevé.

Selon un aspect particulier de l'invention, les trous traversants sont destinés à coopérer avec des moyens de fixation d'un élément de verrouillage intermédiaire formant les moyens de verrouillage et l'encoche est configurée pour coopérer avec un pion de verrouillage de l'élément de verrouillage intermédiaire.

Ainsi, des moyens de verrouillage, par exemple un verrou de type Kensington®, peuvent être fixés sur l'adaptateur par le biais des trous traversants. L'encoche ménagée entre les trous traversants permet ainsi le passage d'un pion de verrouillage, par exemple le pion du verrou Kensington®, qui coopère ensuite avec une ouverture adaptée ménagée dans la coque du terminal de paiement électronique.

L'élément intermédiaire ne peut être déverrouillé que par un outil spécifique, ce qui améliore/augmente la sécurité du terminal de paiement électronique lorsqu'il est solidarisé au support par le biais de l'adaptateur de l'invention. En outre, grâce à l'adaptateur de l'invention, il n'est pas nécessaire de mettre en œuvre de câble de verrouillage additionnel puisque l'élément intermédiaire est directement fixé sur l'adaptateur. La sécurisation du terminal de paiement électronique est donc augmentée de façon relativement simple.

Selon un aspect particulier de l'invention, l'encoche est configurée pour coopérer avec une vis formant les moyens de verrouillage.

Ainsi, une variante des moyens de verrouillage consiste à mettre en œuvre une vis de verrouillage. Une telle vis de verrouillage permet également d'améliorer/augmenter la sécurité du terminal de paiement électronique lorsqu'il est solidarisé au support. Toutefois, le niveau de sécurité d'une telle vis de verrouillage est inférieur au niveau de sécurité fourni par l'élément intermédiaire puisque dans ce cas, un outil classique (un tournevis) permet le déverrouillage du terminal de paiement électronique.

Ainsi, l'adaptateur de l'invention propose à son utilisateur trois niveaux de sécurité, à savoir :
- un premier niveau de sécurisation, dans lequel le terminal de paiement électronique est solidarisé au support uniquement par le clip de solidarisation ;
- un niveau de sécurité intermédiaire, dans lequel le terminal de paiement électronique est solidarisé au support par le clip de solidarisation et sécurisé par une vis de verrouillage ; et
- un niveau de sécurité élevé, dans lequel dans lequel le terminal de paiement électronique est solidarisé au support par le clip de solidarisation et sécurisé par un élément de verrouillage intermédiaire (un verrou de type Kensington, par exemple).

L'invention propose également un terminal de paiement électronique configuré pour coopérer avec un adaptateur tel que décrit précédemment.

Selon l'invention, le terminal de paiement électronique comprend un capot arrière présentant un logement adapté pour recevoir l'adaptateur.

Ainsi, le capot arrière du terminal de paiement électronique présente un logement adapté à la forme du corps de l'adaptateur pour recevoir ce dernier et ne laisser qu'un seul degré de liberté à l'ensemble adaptateur-capot arrière. Le seul degré de liberté autorisé de l'ensemble est celui permettant d'insérer et retirer le terminal de paiement électronique, lorsque le clip de solidarisation le permet.

Selon un aspect particulier de l'invention, le logement présente une rainure d'insertion et de butée du clip de solidarisation de l'adaptateur.

Selon cet aspect particulier, la rainure présente dans le logement permet de recevoir et maintenir le clip de solidarisation de façon à supprimer le dernier degré de liberté de l'assemblage adaptateur-capot arrière pour empêcher le retrait du terminal de paiement électronique de l'adaptateur.

Selon un aspect particulier de l'invention, le capot arrière présente, au voisinage du logement, un trou borgne destiné à coopérer avec les moyens de verrouillage du terminal de paiement électronique sur l'adaptateur.

Selon cet aspect particulier, le trou borgne ménagé dans le capot arrière du terminal de paiement électronique est apte à coopérer soit avec la vis de verrouillage, ou soit avec le pion de verrouillage de l'élément intermédiaire, qui se présente par exemple sous la forme d'un verrou Kensington®. Il est à noter qu'il n'est pas possible de mettre en œuvre à la fois la vis de verrouillage et l'élément intermédiaire.

Ainsi, la mise en œuvre de ce trou borgne permet, par le biais des moyens de verrouillage de sécuriser le terminal de paiement électronique.

### 4. LISTE DES FIGURES

D'autres caractéristiques et avantages de l'invention apparaîtront à la lecture de la description suivante, donnée à titre d'exemple indicatif et non limitatif, et des dessins annexés, parmi lesquels :
- la figure 1 est une vue éclatée des différents éléments, et notamment d'un adaptateur permettant la fixation d'un terminal de paiement électronique à un support, selon un mode de réalisation de l'invention ;
- la figure 2 est une vue éclatée d'un adaptateur selon un mode de réalisation de l'invention ;
- la figure 3 illustre, en perspective, un adaptateur fixé sur un support, selon un mode de réalisation de l'invention ;
- la figure 4A illustre, en perspective, le capot arrière d'un terminal de paiement électronique configuré pour coopérer avec l'adaptateur de la figure 2 ;
- la figure 4b est une vue de détail du capot arrière d'un terminal de la figure 4A.

### 5. DESCRIPTION DÉTAILLÉE

Le principe de l'invention repose sur la mise en œuvre d'un adaptateur comprenant un clip de solidarisation afin de solidariser, de manière réversible et simple, un terminal de paiement électronique à un support (par exemple un pied de support).

### 5.1 Description d'un premier mode de réalisation de l'invention

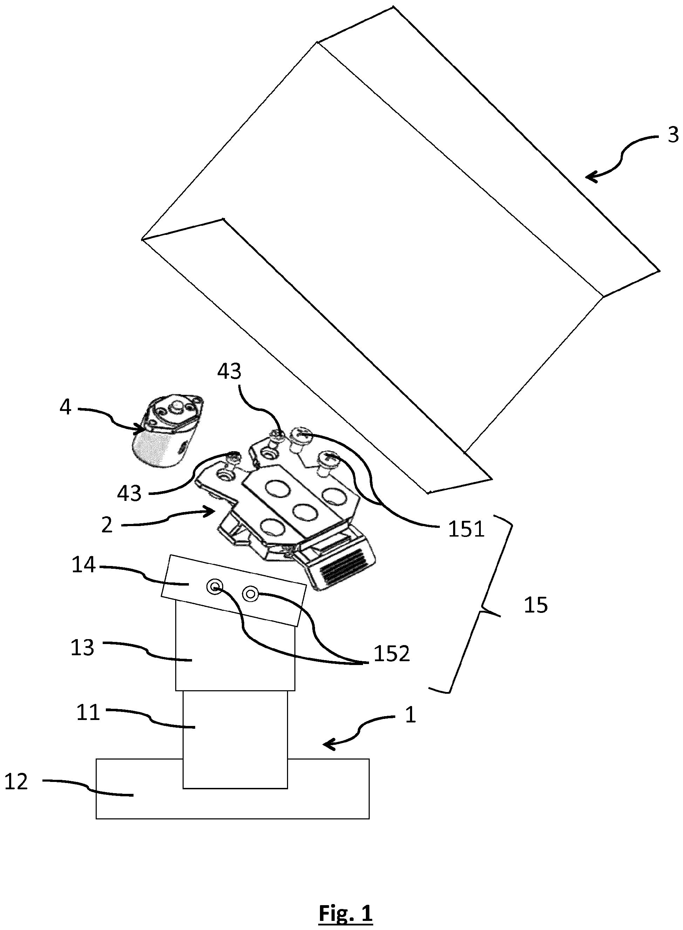

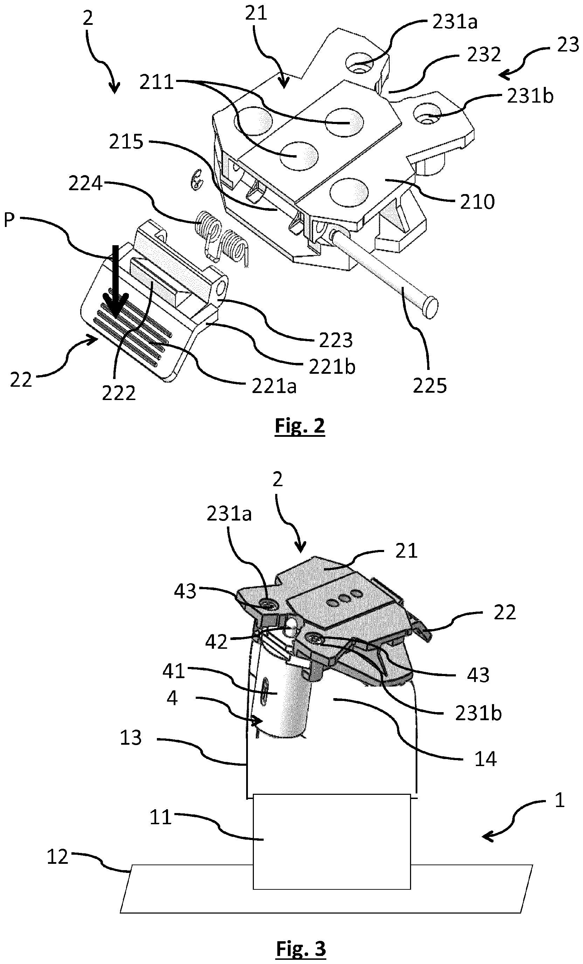

On présente maintenant, en relation avec les figures 1 et 2, une technique de fixation d'un terminal de paiement électronique à un support, mettant en œuvre un adaptateur selon un premier mode de réalisation de l'invention.

Plus précisément, cette technique de fixation met en œuvre un adaptateur 2 par l'intermédiaire duquel un terminal de paiement électronique peut être solidarisé sur un support 1.

Optionnellement, des moyens de verrouillage 4 peuvent être prévus en plus de l'adaptateur 2, afin de sécuriser la fixation du terminal de paiement électronique sur le support 1. Ces moyens de verrouillage seront décrits plus en détails dans les modes de réalisation suivants.

Le support 1, sur lequel le terminal de paiement électronique peut être solidarisé, se présente dans cet exemple sous la forme d'un pied de fixation. Il existe de nombreux exemples de supports pour terminal de paiement électronique, permettant de maintenir le terminal de paiement électronique en position facile d'utilisation, que ce soit pour le commerçant comme pour le client.

Selon l'exemple illustré en figures 1 et 3, le support 1 présente une embase 12 destinée à être solidement fixée au mobilier d'un commerce par exemple. Une partie fixe 11 est solidaire, à une première extrémité, de l'embase 12 et est prolongée, à une deuxième extrémité, par une partie pivotante 13 mobile en rotation par rapport à la partie fixe 11 selon un axe vertical. De cette manière, le terminal de paiement électronique fixé à ce support 1 peut prendre plusieurs positions, notamment lors d'une transaction. Ainsi, le terminal de paiement électronique peut être orienté face au commerçant lorsque celui-ci saisit le montant de la transaction par exemple, puis orienté face au client afin que celui-ci insère sa carte de paiement puis saisisse son code PIN par exemple.

La partie pivotante 13 comporte une tête rotative 14 apte à pivoter selon un axe horizontal. Ce pivotement est notamment utile pour orienter le terminal de paiement électronique plus ou moins horizontalement, afin par exemple de faciliter l'accès aux touches pour la saisie du code PIN.

La tête rotative 14 comprend des moyens de fixation 15 de l'adaptateur 2 sur le support 1. Dans l'exemple illustré sur la figure 1, les moyens de fixation 15 se présentent sous la forme de deux vis de fixation 151 qui passent à travers des trous 211 ménagés dans l'adaptateur 2 et qui coopèrent ensuite avec des trous 152 taraudés ménagés dans la tête rotative 14.

La figure 2 illustre une vue éclatée de l'adaptateur 2 selon ce premier mode de réalisation de l'invention. L'adaptateur 2 comprend un corps 21 qui présente une forme complexe, par exemple une forme générale rectangulaire présentant des angles chanfreinés. On comprend bien évidemment que toute autre forme du corps peut être proposée pour résoudre le problème technique, sans s'éloigner du principe général de l'invention.

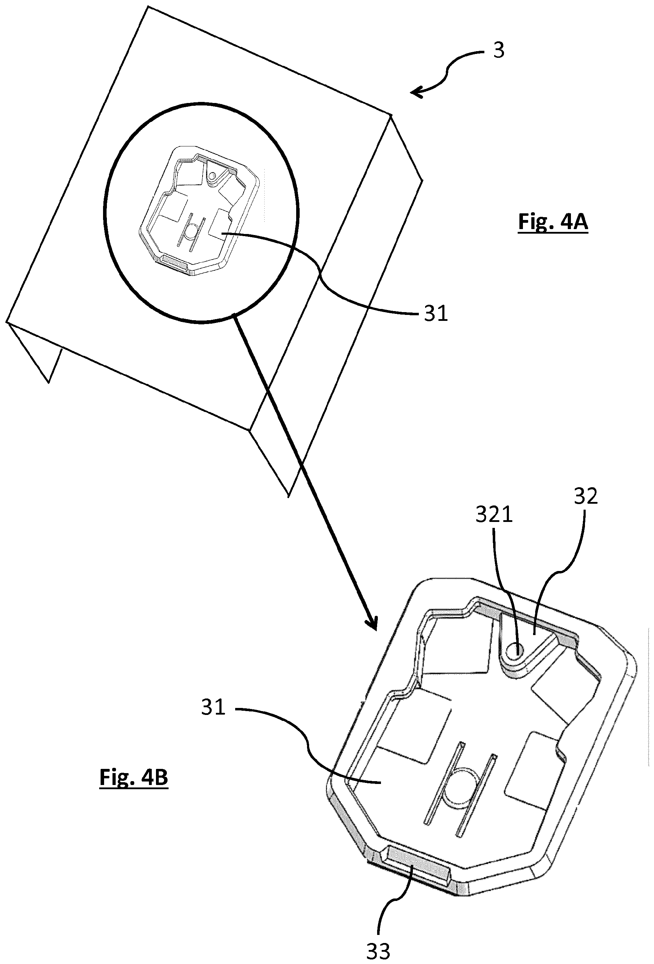

Le corps 21 de l'adaptateur 2 présente une surface inférieure (non visible sur les figures) destinée à venir en appui contre la tête rotative 14 du support 1 et une surface supérieure 210 destinée à coopérer avec le capot arrière 3 du terminal de paiement électronique (illustré par exemple en figures 4A et 4B).

Le corps 21 comprend, sensiblement au centre de ce dernier, deux trous 211 traversants de passage des vis de fixation 151 qui permettent de fixer l'adaptateur 2 sur la tête rotative 14 du support 1.

Selon ce mode de réalisation de l'invention, l'adaptateur 2 comprend un clip 22 de solidarisation qui permet de commander la solidarisation et la désolidarisation du terminal de paiement électronique sur le support 1.

Le clip 22 présente une surface de pression, ou surface d'appui, 221a inclinée et prolongée par une surface rectiligne 221b.

La surface rectiligne 221b comprend un plot de maintien 222 et une base de fixation 223. Le plot de maintien 222 fait saillie par rapport à la surface rectiligne 221b et présente une forme sensiblement triangulaire. La base de fixation 223 du clip 22 présente une lumière circulaire à chacune de ses extrémités.

Le clip 22 est destiné à être solidarisé au corps 21 de l'adaptateur 2. Pour ce faire, le corps 21 comprend un logement 215 ménagé entre les surfaces inférieure et supérieure 210. Le logement 215 est configuré pour recevoir la base de fixation 223 du clip 22 et présente, comme la base de fixation 223, deux lumières circulaires.

Ainsi, une tige de fixation 225, qui passe au travers des lumières de la base de fixation 223 et de celles du logement 215, permet de solidariser la base de fixation 223 du clip 22 au corps 21, tout en permettant au clip 22 de pivoter par rapport au corps 21.

Un élément de rappel 224, se présentant dans cet exemple sous la forme d'un ressort, est disposé dans le logement 215, entre le clip 22 de solidarisation et le corps 21. Un tel élément de rappel 224 permet, lorsqu'un utilisateur exerce une pression sur la surface d'appui 221 du clip, puis la relâche, de rappeler le clip 22 dans une position dite nominale ou de repos.

Lors de la solidarisation du terminal de paiement électronique sur l'adaptateur 2, l'utilisateur tient le terminal de paiement dans sa main et vient mettre en contact ce dernier contre l'adaptateur 2. En appuyant sur le terminal de paiement, l'utilisateur réalise une pression qui s'effectue dans une direction verticale et vers le bas comme indiqué par la flèche « P » illustrée sur la figure 2. L'élément de rappel 224 se trouve alors dans une position comprimée (non illustrée). Lorsque la pression de l'utilisateur sur le terminal de paiement, et donc sur le clip 22, n'est plus maintenue, l'élément de rappel 224 permet de ramener le clip 22 dans sa position nominale (celle illustrée sur les figures 1 et 2).

Cette mise en œuvre des différents éléments formant l'adaptateur 2 selon ce mode de réalisation permet ainsi une fixation aisée et sans outil du terminal de paiement électronique sur un support 1. En effet, comme indiqué ci-dessus, une simple pression de l'utilisateur sur le terminal de paiement lorsque ce dernier est en contact avec l'adaptateur 2 déplace le clip 22 de solidarisation et permet de positionner le terminal de paiement électronique sur le corps 21 de l'adaptateur 2, le terminal de paiement électronique étant maintenu sur l'adaptateur lorsque la pression de l'utilisateur est relâchée. De la même manière, si l'utilisateur (par exemple le commerçant) souhaite désolidariser le terminal de paiement électronique du support 1, il exerce une pression directement sur le clip 22 de l'adaptateur 2, permettant de libérer le terminal de paiement électronique du corps 21 de l'adaptateur 22.

L'adaptateur 2 comprend, en outre, sur un bord de sa surface supérieure 210 (le bord supérieur du corps 21 comme illustré sur la figure 2) des moyens de réception 23 de moyens de verrouillage 4 du terminal de paiement électronique sur l'adaptateur 2.

Les moyens de réception 23 comprennent deux trous traversants 231a, 231b situés de part et d'autre d'une encoche 232. La mise en œuvre des moyens de réception 23 des moyens de verrouillage 4 du terminal de paiement électronique sur l'adaptateur 2 sera décrite plus en détail en relation avec les autres modes de réalisation de l'invention.

Comme illustré sur les figures 4A et 4B, le capot arrière 3 d'un terminal de paiement électronique est adapté pour coopérer avec l'adaptateur 2. Plus précisément, le capot arrière 3 présente un logement 31 de forme correspondant à la forme de la surface supérieure 210 du corps 21 de l'adaptateur 2.

Ainsi, le corps 21 de l'adaptateur 2 est reçu dans le logement 31 du capot arrière 3, afin de maintenir le terminal de paiement électronique sur l'adaptateur (lui-même fixé sur le support 1 par exemple). Les formes correspondantes du corps 21 et du logement 31 permettent de ne laisser qu'un seul degré de liberté à l'assemblage, celui permettant l'insertion et le retrait du corps 21 de l'adaptateur 2 dans le logement 31 du capot arrière 3 du terminal de paiement électronique.

Selon ce mode de réalisation, le logement 31 comprend, au voisinage d'un de ses bords (par exemple le bord supérieur illustré sur la figure 4B) une protubérance 32 destinée à coopérer, lorsque l'adaptateur 2 est solidarisé au capot arrière 3, avec l'encoche 232 de l'adaptateur 2.

La protubérance 32 présente un trou borgne 321 apte à coopérer avec les moyens de verrouillage 4 du terminal de paiement électronique sur le support 1, via l'adaptateur 2 (décrits dans les modes de réalisation suivants).

Le capot arrière 3 comprend en outre, au voisinage d'un autre bord du logement 31 (le bord inférieur sur la figure 4B), une rainure 33 destinée à coopérer avec le plot de maintien 222 du clip 22 de solidarisation, permettant ainsi au terminal de paiement électronique d'être maintenu sur l'adaptateur 2.

La solidarisation d'un terminal de paiement électronique sur le support 1 est donc très simple.

En effet, après avoir fixé de façon définitive l'adaptateur 2 sur le pied de fixation 1 (par le biais des vis de fixations 151 par exemple), il suffit de venir clipper le terminal de paiement électronique sur l'adaptateur 2. Cette opération ne nécessite aucune action supplémentaire de la part de l'utilisateur puisque lorsque le terminal est amené en contact contre l'adaptateur 2 par l'utilisateur, la rainure 33 du capot arrière 3 guide le plot de maintien 222 du clip 22 et comprime l'élément de rappel 224. Ainsi, l'adaptateur 2 peut être inséré dans le logement 31 du capot arrière 3 et maintenu dans ce dernier par l'interaction entre le plot de maintien 222 et la rainure 33.

Dans une variante, la solidarisation du terminal de paiement sur l'adaptateur 2 peut nécessiter une pression de l'utilisateur sur la surface de pression 221a du clip 2 afin de déplacer l'élément de rappel 224 dans sa position comprimée, permettant ainsi l'insertion du corps 21 dans le logement 31 du capot arrière 3.

La désolidarisation du terminal de paiement électronique se fait également par une simple pression P de l'utilisateur sur la surface de pression du clip 22 pour comprimer l'élément de rappel 224 et permettre le retrait de l'adaptateur 2 du logement 31 du capot arrière 3.

Ainsi, la solidarisation et la désolidarisation du terminal de paiement électronique sur le support sont simples et rapides. De plus, ces opérations ne nécessitent pas d'outil, qu'il soit classique ou spécifique.

### 5.2 Description d'un deuxième mode de réalisation de l'invention

Dans un deuxième mode de réalisation particulier de l'invention, illustré sur la figure 3, il est possible de mettre en œuvre, de façon optionnelle, des moyens de verrouillage 4 (du terminal de paiement électronique sur le support 1 via l'adaptateur 2) se présentant sous la forme d'un élément de verrouillage intermédiaire 41.

Dans l'exemple illustré, l'élément de verrouillage intermédiaire 41 se présente sous la forme d'un verrou de type Kensington® (marque déposée). Ce type de verrou 41 est bien connu pour sécuriser des dispositifs électroniques comme des ordinateurs, par exemple.

Ici, le verrou 41 Kensington® a été adapté afin d'être fixé directement (et non via un câble) à l'adaptateur 2, par le biais de deux vis de fixation 43 qui coopèrent respectivement avec les trous traversants 231a et 231b de l'adaptateur 2.

Un pion de verrouillage 42 de l'élément intermédiaire 41 fait saillie par rapport à la surface supérieure de l'élément intermédiaire 41 (comme illustré sur la figure 3) et se situe ainsi dans l'encoche 232 prévue dans le corps 21 de l'adaptateur.

Le pion de verrouillage 42 est ainsi apte à coopérer avec le trou borgne 321 du capot arrière 3 du terminal de paiement électronique afin de verrouiller ce dernier sur l'adaptateur 2 et ainsi sécuriser la fixation du terminal de paiement électronique.

Le verrouillage et le déverrouillage de l'élément intermédiaire 41 se fait, classiquement et de manière connue, par le biais d'un outil spécifique telle une clé.

La mise en œuvre d'un tel élément intermédiaire 41 permet de s'affranchir de l'utilisation d'un câble de verrouillage et facilite ainsi la sécurisation de la fixation du terminal de paiement électronique.

Il convient de noter que l'élément de verrouillage intermédiaire 41 vient agir en complément du clip 22 de solidarisation du terminal de paiement électronique au support 1. Ainsi, l'élément de verrouillage intermédiaire 41 permet d'apporter un niveau de sécurité supplémentaire, optionnel, par rapport à l'utilisation du clip 22 seul.

### 5.3 Description d'un troisième mode de réalisation de l'invention

Dans un troisième mode de réalisation particulier de l'invention (non illustré), il est possible de mettre en œuvre, de façon optionnelle également, des moyens de verrouillage 4 se présentant sous la forme d'une vis de verrouillage.

Une telle vis de verrouillage est destinée à venir sécuriser la fixation du terminal de paiement électronique sur le support 1.

Pour ce faire, une pièce intermédiaire est montée sur le corps 21 de l'adaptateur 2 et est maintenue sur ce dernier par deux vis de maintien coopérant avec les trous traversants 231a et 231b de l'adaptateur 2.

La pièce intermédiaire comprend un trou taraudé qui est destiné à recevoir la vis de verrouillage. Plus précisément, la tête de la vis de verrouillage vient en contact contre la surface inférieure de la pièce intermédiaire et la tige filetée de la vis de verrouillage s'étend à travers le trou taraudé jusqu'à coopérer avec le trou borgne 321 du capot arrière 3 du terminal de paiement électronique afin de verrouiller et ainsi sécuriser la fixation du terminal de paiement électronique sur l'adaptateur 2, et donc sur le support 1.

Comme pour l'élément de verrouillage intermédiaire 41, la vis de verrouillage vient agir en complément du clip 22 de solidarisation du terminal de paiement électronique au support 1. Ainsi, cette vis de verrouillage permet d'apporter un niveau de sécurité supplémentaire par rapport à l'utilisation du clip 22 seul.

Toutefois le verrouillage/déverrouillage du terminal nécessite un tournevis, donc un outil classique. Par conséquent, le niveau de sécurité apporté par la vis de verrouillage offre un niveau intermédiaire de sécurisation de la fixation du terminal de paiement électronique sur le support, entre le clip 22 de solidarisation seul (premier niveau de sécurisation) et la combinaison du clip 22 de solidarisation et l'élément intermédiaire 41 (niveau élevé de sécurisation car nécessitant un outil spécifique).

### 5.4 Autres aspects et variantes

L'adaptateur 2 de l'invention peut présenter, selon les différents modes de réalisation décrits ci-dessus, trois niveaux de sécurité, à savoir :
- un premier niveau de sécurité, lorsque le terminal de paiement électronique est solidarisé par le clip 22 seul ;
- un deuxième niveau de sécurité, dit intermédiaire, lorsque le terminal de paiement électronique est solidarisé par le clip 22 et sécurisé par la vis de verrouillage ; et
- un troisième niveau de sécurité, dit élevé, lorsque le terminal de paiement électronique est solidarisé par le clip 22 et sécurisé par l'élément intermédiaire 41.

L'adaptateur 2 de l'invention peut également être mis en œuvre pour des terminaux de paiement électronique sans fil qui sont désolidarisés de leur support (la base de chargement par exemple) pour que le client puisse effectuer la transaction en toute confidentialité (insertion de la carte + saisie du code PIN).

## Revendications

1. Adaptateur (2) pour la solidarisation réversible d'un terminal de paiement électronique à un support (1), ledit adaptateur (2) comprenant un corps (21) sur lequel est monté un clip (22) de solidarisation réversible dudit terminal de paiement électronique audit support (1), ledit adaptateur (2) étant fixé audit support (1) et la désolidarisation dudit terminal de paiement électronique dudit support (1) étant obtenue par une pression d'un utilisateur sur ledit clip, **caractérisé en ce que** ledit corps (21) présente en outre au moins deux trous traversants (231a, 231b) situés de part et d'autre d'une encoche (232) et destinés à coopérer avec des moyens de verrouillage (4) dudit terminal de paiement électronique sur ledit adaptateur (2).

2. Adaptateur (2) selon la revendication 1, **caractérisé en ce que** ledit clip (22) est monté pivotant sur ledit corps (21) dudit adaptateur (2).

3. Adaptateur (2) selon la revendication 2, **caractérisé en ce que** ledit clip (22) présente un élément de rappel (224) situé entre ledit clip (22) et ledit corps (21).

4. Adaptateur (2) selon la revendication 3, **caractérisé en ce que** ledit élément de rappel (224) se présente sous la forme d'un ressort.

5. Adaptateur (2) selon l'une des revendications 1 à 4, **caractérisé en ce que** ledit corps (21) présente au moins un trou (211) de passage de moyens de fixation (15) dudit adaptateur (2) sur ledit support (1).

6. Adaptateur (2) selon l'une des revendications 1 à 5, **caractérisé en ce que** lesdits trous traversants (231a, 231b) sont destinés à coopérer avec des moyens de fixation (43) d'un élément de verrouillage intermédiaire (41) formant lesdits moyens de verrouillage (4) et ladite encoche (232) est configurée pour coopérer avec un pion de verrouillage (42) dudit élément de verrouillage intermédiaire (41).

7. Adaptateur (2) selon la revendication 5, **caractérisé en ce que** ladite encoche (232) est configurée pour coopérer avec une vis formant lesdits moyens de verrouillage (4).

8. Terminal de paiement électronique configuré pour coopérer avec un adaptateur (2) selon l'une des revendications 1 à 7, **caractérisé en ce qu'**il comprend un capot arrière (3) présentant un logement (31) adapté pour recevoir ledit adaptateur (2).

9. Terminal de paiement électronique selon la revendication 8, **caractérisé en ce que** ledit logement (31) présente une rainure (33) d'insertion et de butée dudit clip (22) de solidarisation dudit adaptateur (2).

10. Terminal de paiement électronique selon la revendication 8 ou 9, **caractérisé en ce que** ledit capot arrière (3) présente, au voisinage dudit logement (31), un trou borgne (321) destiné à coopérer avec lesdits moyens de verrouillage (4) dudit terminal de paiement électronique sur ledit adaptateur (2).

## Patentansprüche

1. Adapter (2) zum reversiblen Befestigen eines elektronischen Zahlungsterminals auf einer Halterung (1), dass der Adapter (2) einen Körper (21) aufweist, an dem eine Klammer (22) zum reversiblen Befestigen des elektronischen Zahlungsterminals an der Halterung (1) angebracht ist, wobei der Adapter (2) an der Halterung (1) befestigt ist und das Lösen des elektronischen Zahlungsterminals von der Halterung (1) durch einen Druck eines Benutzers auf die Klammer erhalten wird, **dadurch gekennzeichnet, dass** der Körper (21) ferner mindestens zwei Durchgangslöcher (231a, 231b) aufweist, die sich auf beiden Seite einer Kerbe (232) befinden und dazu bestimmt sind, mit Verriegelungsmitteln (4) des elektronischen Zahlungsterminals an dem Adapter (2) zusammenzuwirken.

2. Adapter (2) nach Anspruch 1, **dadurch gekennzeichnet, dass** die Klammer (22) schwenkbar an dem Körper (21) des Adapters (2) angebracht ist.

3. Adapter (2) nach Anspruch 2, **dadurch gekennzeichnet, dass** die Klammer (22) ein Rückstellelement (224) aufweist, das sich zwischen der Klammer (22) und dem Körper (21) befindet.

4. Adapter (2) nach Anspruch 3, **dadurch gekennzeichnet, dass** das Rückstellelement (224) die Form einer Feder aufweist.

5. Adapter (2) nach einem der Ansprüche 1 bis 4, **dadurch gekennzeichnet, dass** der Körper (21) mindestens ein Loch (211) zum Durchgang von Befestigungsmitteln (15) des Adapters (2) an der Halterung (1) aufweist.

6. Adapter (2) nach einem der Ansprüche 1 bis 5, **dadurch gekennzeichnet, dass** die Durchgangslöcher (231a, 231b) dazu bestimmt sind, mit Befestigungsmitteln (43) eines Zwischenverriegelungselements (41) zusammenzuwirken, das die Verriegelungsmittel (4) bildet, und die Kerbe (232) konfiguriert ist, um mit einem Verriegelungsstift (42) des Zwischenverriegelungselements (41) zusammenzuwirken.

7. Adapter (2) nach Anspruch 5, **dadurch gekennzeichnet, dass** die Kerbe (232) konfiguriert ist, um mit einer Schraube zusammenzuwirken, die die Verriegelungsmittel (4) bildet.

8. Elektronisches Zahlungsterminal, das konfiguriert ist, um mit einem Adapter (2) nach einem der Ansprüche 1 bis 7 zusammenzuwirken, **dadurch gekennzeichnet, dass** es eine hintere Abdeckung (3) aufweist, die eine Aufnahme (31) aufweist, die geeignet ist, um den Adapter (2) aufzunehmen.

9. Elektronisches Zahlungsterminal nach Anspruch 8, **dadurch gekennzeichnet, dass** die Aufnahme (31) eine Nut (33) zum Einfügen und Anschlagen der Klammer (22) zum Befestigen des Adapters (2) aufweist.

10. Elektronisches Zahlungsterminal nach Anspruch 8 oder 9, **dadurch gekennzeichnet, dass** die hintere Abdeckung (3) in der Nähe der Aufnahme (31) ein Sackloch (321) aufweist, das dazu bestimmt ist, mit den Verriegelungsmitteln (4) des elektronischen Zahlungsterminals an dem Adapter (2) zusammenzuwirken.

## Claims

1. Adaptor (2) for the reversible fixed attachment of an electronic payment terminal to a support (1), that said adaptor (2) comprising a body (21) on which there is mounted a clip (22) for the reversible fixed attachment of said electronic payment terminal to said support (1), said adaptor (2) being fixed to said support (1) and the detachment of said electronic payment terminal from said support (1) being obtained by pressure applied by a user on said clip, **characterized in that** said body (21) further has at least two through holes (231a, 231b) situated on either side of a notch (232) and intended for cooperating with means (4) for locking said electronic payment terminal to said adaptor (2)..

2. Adaptor (2) according to claim 1, **characterized in that** said clip (22) is mounted pivotingly on said body (21) of said adaptor (2).

3. Adaptor (2) according to claim 2, **characterized in that** said clip (22) has a return element (224) situated between said clip (22) and said body (21).

4. Adaptor (2) according to claim 3, **characterized in that** said return element (224) takes the form of a spring.

5. Adaptor (2) according to one of the claims 1 to 4, **characterized in that** said body (21) has at least one hole (221) for the passage of the means (15) for affixing said adaptor (2) to said support (1).

6. Adaptor (2) according to one of the claims 1 to 5, **characterized in that** through holes (231a, 231b) are meant to cooperate with means (43) for affixing an intermediate locking element (41) forming said locking means (4) and said notch (232) is configured to cooperate with a locking pin (42) of said intermediate locking element (41).

7. Adaptor (2) according to claim 5, **characterized in that** said notch (232) is configured to cooperate with a screw forming said locking means (4).

8. Electronic payment terminal configured to cooperate with an adaptor (2) according to one of the claims 1 to 7, **characterized in that** it comprises a rear cover (3) having a housing (31) adapted for receiving said adaptor (2).

9. Electronic payment terminal according to claim 8, **characterized in that** housing (31) has a groove (33) for the insertion and stopping of said clip (22) for the fixed attachment of said adaptor (2).

10. Electronic payment terminal according to claim 8 or 9, **characterized in that**, in the vicinity of said housing (31), said rear cover (3) has a blind hole (321) that is meant to cooperate with said means (4) for locking said electronic payment terminal to said adaptor (2).
